Europäisches Patentamt

European Patent Office

Office européen des brevets

(19)

(11) Publication number: **0 138 563**
A2

# EUROPEAN PATENT APPLICATION

(21) Application number: **84306893.3**

(22) Date of filing: **10.10.84**

(51) Int. Cl.⁴: **H 01 L 29/72**

(30) Priority: **12.10.83 JP 191188/83**

(43) Date of publication of application: **24.04.85**
**Bulletin 85/17**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Nakano, Motoo c/o Fujitsu Limited, Patent Department 1015 Kamikodanaka, Nakahara-ku Kawasaki-shi Kanagawa, 211 (JP)**

(74) Representative: **Sunderland, James Harry et al, HASELTINE LAKE & CO Hazlitt House 28 Southampton Buildings Chancery Lane, London WC2A 1AT (GB)**

(54) **Lateral transistors.**

(57) A lateral bipolar transistor having a silicon on insulator substrate structure, having a base region (13, 15, 17), a base contact region (16), a collector region (14), and a emitter region (12). The base region comprises a first base region (13), with a narrow width, forming a base-emitter junctiton and a base-collector junction. The base region also comprises a second base region (17) connecting the first base region (13) and the base contact region (16) with a greater width than the first base region (13) and forming a base-collector junction.

EP 0 138 563 A2

0138563

## LATERAL TRANSISTORS

The present invention relates to lateral transistors.

In this document, "lateral" refers to a direction parallel to a surface of a (semiconductor) substrate (in which a "lateral" transistor is formed) and "vertical" refers to a direction perpendicular to the surface of the substrate.

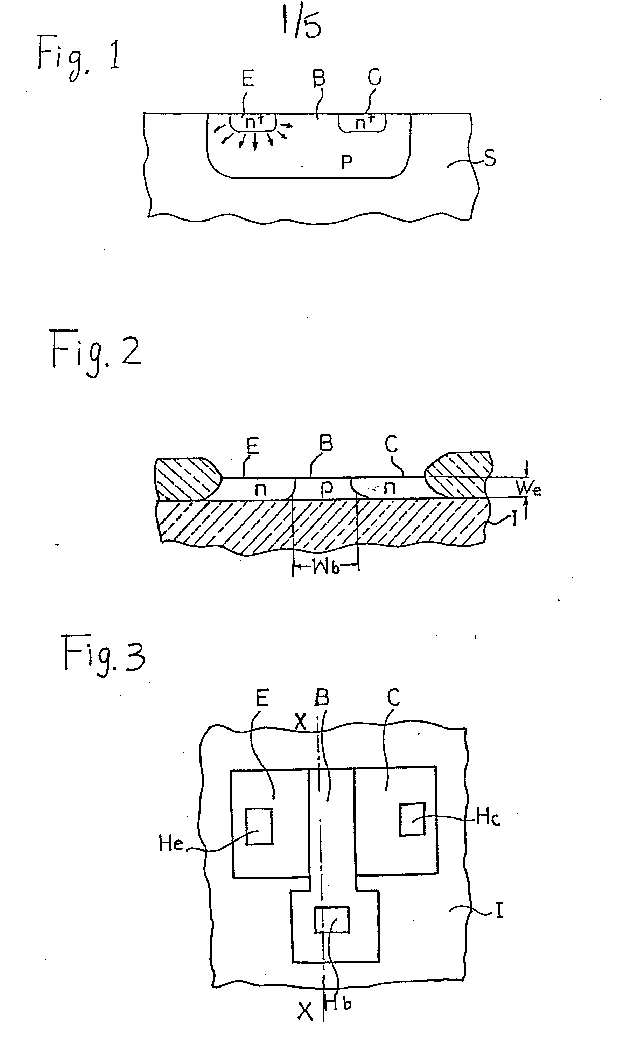

A schematic cross-sectional view of a basic structure of a previously proposed lateral transistor, formed in a semiconductor substrate of an integrated circuit (IC) semiconductor device, is illustrated in Fig. 1. The structure differs most radically from other (vertical) transistor structures in that transistor action is performed in a lateral direction rather than in a vertical direction.

A lateral transistor is used advantageously, because of its simple structure, for example in building a pnp transistor in the course of processes for fabricating an npn structure, or vice versa, without requiring an additional process.

Recently, lateral transistors have been proposed for use in logic IC's having metal insulator silicon (MIS) field effect transistors (FET) as dominant active elements, for example MIS memory IC's. A bipolar transistor is suitable for driving elements for peripheral circuits to such an IC. Such driving elements are required to provide high current outputs because of parasitic capacitances associated with wiring interconnections to peripheral circuits. If MIS transistors are used for such driving elements, they occupy areas of significant size as MIS transistors have low transconductance. This has an adverse effect on the level of packing density which can be achieved. Accordingly, a combination of MIS transistors and lateral (bipolar) transistors may be expected to be effective when employed in such a semiconductor device (IC).

A previously proposed lateral transistor has a structure as shown in Fig. 1, in which an emitter region E and a collector region C, formed with $n^+$ type doping for example, are formed separately in a p-type doped base region B formed in a substrate S. Carriers from the emitter region E are transported in all directions in the base region B (as indicated by arrows in Fig. 1) and most of the carriers fail to reach the collector region. This means that the transportation efficiency of carriers in the base region is low, resulting in a low current amplification factor for the lateral transistor structure. In addition, parasitic capacitances are so high as to result in a low switching speed for the lateral transistor.

In an effort to avoid these disadvantages, lateral transistor structures have been proposed in which the base region, except for a portion thereof positioned between emitter and collector regions, is removed by etching, or in which all regions are formed on an insulator I or an SOI substrate for example as shown in the schematic cross-sectional view of Fig. 2 and the corresponding plan view of Fig. 3.

In Fig. 1, Fig. 2 and Fig. 3, like reference signs are used for like parts.

In the structure of Figs. 2 and 3, carriers injected into the base region are concentrated into a portion between the emitter region E and the collector region C, resulting in an increase in transportation efficiency of the carriers. Also the parasitic capacity of each region is small. However, a problem still remains.

Generally, carrier transportation efficiency goes up as the lateral width of the base region B (this will be referred as "base width" in the following) becomes smaller. As shown in Fig. 3, for the emitter region E and the collector region C, electrode structures having a contact hole, He or Hc, opened in an insulator layer covering the relevant region, are used. However such a structure as employed for emitter and collector regions is not applicable to the base region B because of its narrow base width. The base region, accordingly, is extended in a longitudinal direction to an outside area (beyond the emitter and collector regions), where a contact hole Hb is formed for a base electrode. Therefore, the longitudinal resistance of the base region B as seen from the base contact becomes high, causing the actual base-emitter junction voltage along the junction to drop below the value expected from the externally applied voltages. This results in decrease in efficiency of injection of carriers from the emitter region E to the base region B. Hence, the characteristics of the transistor are seriously degraded.

According to the present invention there is provided a lateral bipolar transistor, having a structure with a base region, a base contact region, an emitter region and a collector region, the base region comprising:

a first base region forming an emitter-base junction with the emitter region and a base-collector junction with the collector region; and

a second base region connecting the first base region to the base contact region and forming a base-collector junction with the collector region,

the base region, the emitter region and the collector region each being in surface-to-surface contact with an underlying insulator substrate portion.

An embodiment of the present invention can provide a lateral transistor formed on a silicon on insulator (SOI) substrate with an enhanced current amplification factor.

An embodiment of the present invention can provide a lateral transistor with a high current

-4-

transconductance.

An embodiment of the present invention can provide a bipolar lateral transistor having a base region structure such as to reduce the voltage drop along the emitter-base junction.

Reference is made, by way of example, to the accompanying drawings, in which:-

Fig. 1 is a schematic cross-sectional view of a previously proposed lateral bipolar transistor formed in a semiconductor substrate,

Fig. 2 is a schematic cross-sectional view of another previous proposed lateral bipolar transistor,

Fig. 3 is a schematic plan view of the lateral bipolar transistor of Fig. 2;

Fig. 4 is a schematic plan view of a lateral bipolar transistor formed on a SOI substrate and embodying the present invention;

Fig. 5 is a schematic cross-sectional view of the lateral bipolar transistor of Fig. 4, taken along the line A-A in Fig. 4;

Fig. 6 is a schematic cross-sectional view of the lateral bipolar transistor of Fig. 4, taken along the line B-B in Fig. 4;

Fig. 7 is a graph illustrating a base-emitter-junction voltage distribution along the line X-X (i.e. along the base region) in Fig. 3;

Fig. 8 is a graph illustrating a base-emitter-junction voltage distribution along the line Y-Y (i.e. along the first base region) in Fig. 4;

Figs. 9 to 12 are respective schematic cross-sectional views illustrating respective steps in fabrication of the lateral bipolar transistor shown in Fig. 4, Fig. 9 illustrates an SOI substrate for the lateral transistor, Fig. 10 illustrates a structure attained after boron implantation into a base contact region, Fig. 11 illustrates a structure attained after phosphorus implanation into an emitter region and a collector region, and Fig 12. illustrates a structure attained after a wiring step is finished,

Figs. 13 to 17 are respective schematic plan views of respective further lateral bipolar transistors embodying the present invention, and

Fig. 18 is a schematic circuit diagram illustrating a circuit using CMOS and lateral bipolar transistors, for example lateral bipolar transistors as shown in Fig. 16 or 17.

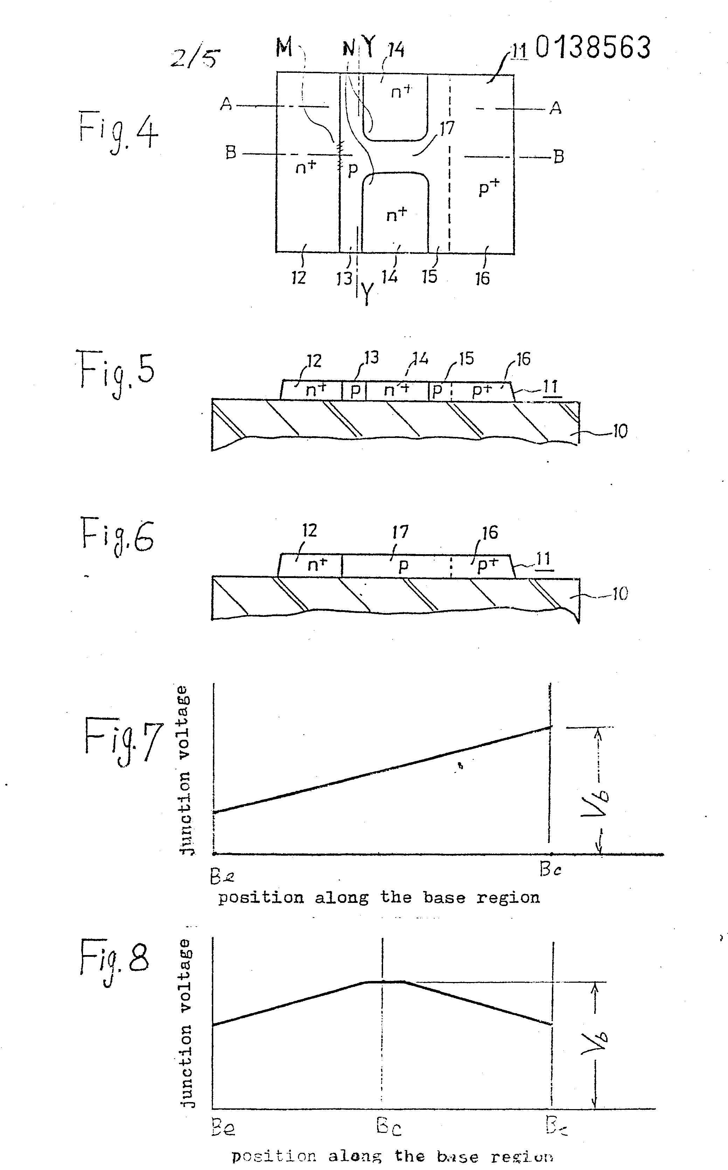

First, a brief introductory explanation of features of embodiments of the present invention will be given. As shown in the plan view of Fig. 4, in a lateral transistor embodying the present invention a base region is comprised of two parts called here a first base region 13 and a second base region 15, 17. For convenience, the second base region is considered as divided roughly into two portions 15 and 17 as shown in Fig. 4. 17 denotes a "connecting" portion of the second base region which serves to connect the first base region 13 to base contact 16 of the transistor. The first base region 13 generally corresponds to the base region of a previously proposed lateral transistor. The first base region has a narrow base width such as one $\mu$m. The second base region 15(17) plays the role of a connecting portion for the first region 13 and extends from the first base region in a lateral direction. The second base region 15(17) will, usually, be of the same dopant density as that of the first base region 13 and (the connecting portion 17) of greater width, for example three to four $\mu$m. The second base region is in this way, for example, provided with a significantly lower longitudinal resistance than that of the first base region 13. The first base region 13 forms the base-emitter junction with an emitter region 12 and a base-collector junction with a collector region 14. The second base region (connecting portion 17) runs across the collector region 14 of the transistor dividing it into two or more portions (sub-collector regions). These sub-collector regions are generally rectangular in shape, as seen in Fig. 4. The second base region shares a part of the collector-base junction with the collector region 14. The second base region 15 joins base contact region 16 which is highly dosed and plate the role of a contact area for the whole base region. This is effective to enhance the current amplification factor of the lateral transistor in comparison with the previously proposed lateral transistor. The reason is as follows.

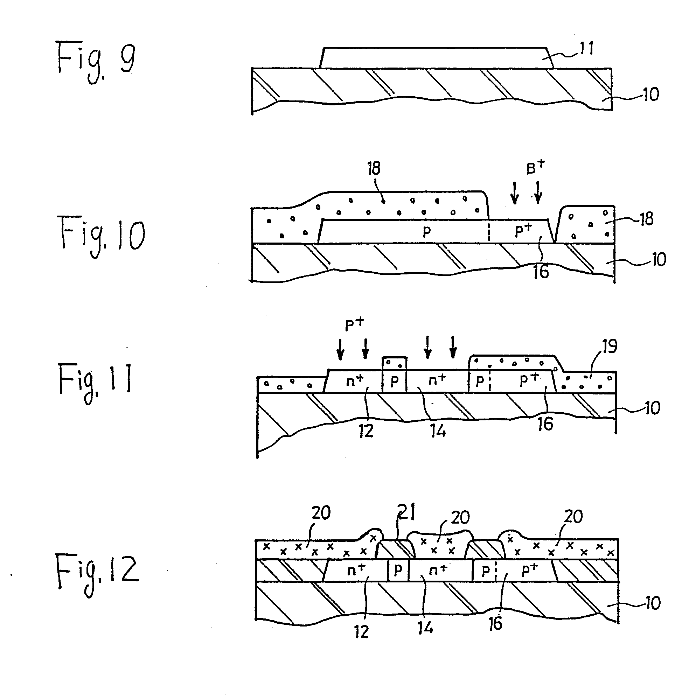

The graphs of Fig. 7 and Fig. 8 illustrate respectively base-emitter junction voltage distribution along the line X-X of the base region B shown in Fig. 3 and voltage distribution along the line Y-Y of the first base region 13 shown in Fig. 4, when an external voltage Vb is applied to the base contacts of those regions. As stated previously, the base width (of region B and of first base region 13) is very narrow, providing a high longitudinal resistance. Accordingly, with the previously-proposed lateral transistor shown in Fig. 2 and Fig. 3, the voltage distribution shows a considerable sharp drop along the base region. Therefore, the voltage applied to the base-emitter junction decreases from the point Bc, where the base contact is connected, toward the end of the junction Be. Accordingly, carriers injected through the junction decrease sharply depending on the decrease of the base-emitter junction voltage. However, with the transistor embodying the present invention shown in Fig. 4, the contact point of the base region is located towards the middle of the base-emitter junction. Therefore, as can clearly be seen from Fig. 8, the voltage drop along the base-emitter junction in total is significantly reduced, resulting in an increase in the number of carriers injected into the base region through the junction. In addition, carriers injected into the base region which arrive a positions around corners N of the divided portions (sub-collector regions) of the collector region can be collected by the collector before recombination of the carriers, because the base-collector junction is formed also between the second base region and the collector region. This reduces loss of carriers, increasing carrier transportation efficiency.

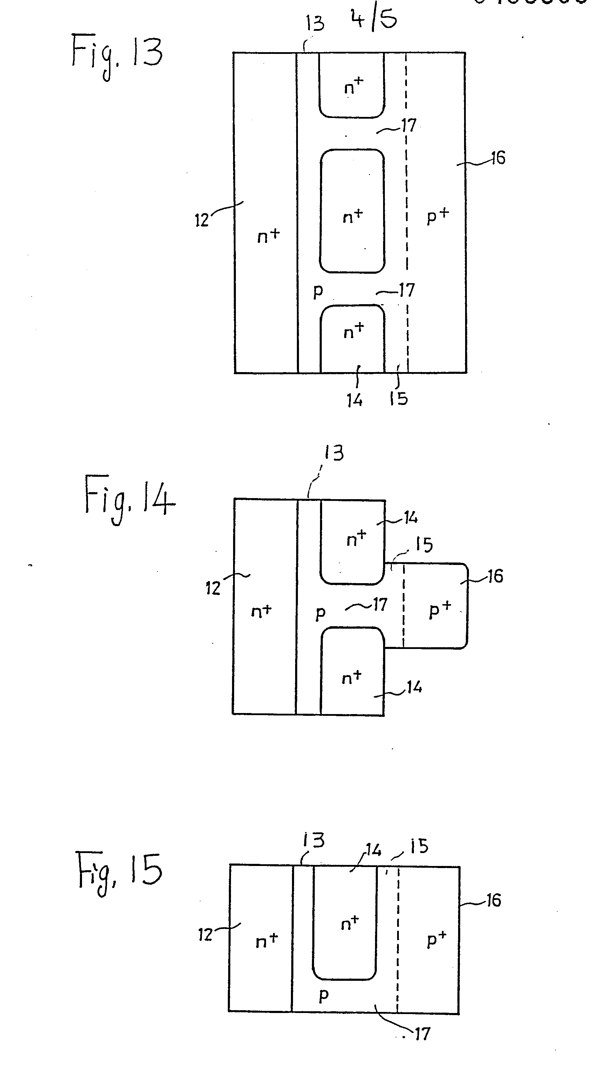

In embodiments of the present invention there may be more than one second base region. Fig. 13 illustrates an embodiment having two second base regions. With such a structure, the total drop of the base-emitter voltage can be reduced further.

Furthermore, emitter-base and collector-base parasitic capacities become small, providing a transistor with a higher switching speed.

From the point of view of a high density packaged integrated semiconductor (IC) device, a bipolar lateral transistor in accordance with an embodiment of the present invention having a high current amplification factor is useful to save the space on a substrate by replacing MOS-type elements. The ease of fabrication of a lateral transistor into IC devices is also a substantial advantage.

A twinned lateral bipolar transistor can be obtained in accordance with an embodiment of the present invention, for example having providing two lateral bipolar transistors with a common emitter electrode or common collector electrode. Such a twinned lateral transistor is particularly suitable for a driving element of an IC device for circuits to drive associated circuits.

Now, a more detailed description of embodiments of the present invention will be given. First, reference will be made to the plan view of a lateral bipolar transistor formed in a SOI substrate according to an embodiment of the present invention as given in Fig. 4, and to the cross-sectional views of Figs. 5 and 6, taken along the lines A-A and B-B in Fig. 4.

Throughout all of Figures 4 to 17, like reference numerals are used for like parts.

In the lateral transistor of Fig. 4, a SOI (silicon on insulator) substrate comprises an insulator layer 10 and a monocrystal silicon layer (not shown). On the insulator layer 10, for example a silicon dioxide ($SiO_2$) layer, a transistor region 11 of monocrystal silicon is formed.

As shown in Fig. 4, an $n^+$- type doped emitter region 12, a p-type doped first base region 13, an $n^+$-type doped collector region 14, divided into two portions (sub-collector regions), a p-type doped second base region 15(17) and a $p^+$- type-doped base contact region 16 are formed in the transistor region 11 using conventional semiconductor fabrication methods.

The base region of the lateral transistor comprises the first base region 13 and the second base region 15 and has a base contact region 16. The first base region 13 plays substantially the same part as the base region B of the previously proposed lateral transistor. The first base region 13 forms the base-emitter junction of the transistor. (The first base region 13 forms only part of the base-collector junction). The first base region 13 has an extremely small base width, for example in the order of 1 to 2 um, to reduce loss of carriers injected through the emitter-base junction during their travel through the first base region 13. The second base region 15 includes connecting portion 17, which serves for connecting the first base region 13 and the base contact region 16. The width of the connecting portion 17 is greater than that of the first base region 13, for example in the order of 3 to 4 um, to reduce resistance in its longitudinal direction to reduce voltage drop, due to base current, between the first base region 13 and the base contact region 16.

Base-collector junctions are formed along the boundary between the collector region 14 (sub-collector regions) and the base region 13, 17, and 15 as shown in Fig. 4. Most carriers injected into the first base region 13 (from the emitter region 12) travel through the first base region 13 to reach the collector region 14. However, carriers injected through the emitter-base junction where it encounters (faces) the connecting portion 17 of the second base region 15 (see the hatched portion of the junction labelled M in Fig. 4) become stray carriers which fail to reach the collector region 14 (across the base region 13). Nevertheless, as stated above junctions formed along the boundary between the collector region 14 and the connecting portion 17 can absorb the stray carriers at corners of the collector region 14, labelled N in Fig. 4. Considering that the emitter-base junction voltage is highest at the hatched portion M (see Fig. 8) the survival (absorbtion) of such stray carriers is effective to enhance the number of carriers reaching the collector 14.

As seen in Fig. 4, the connecting portion 17 of the second base region divides the collector region 14 into two portions (sub-collector regions) each of geneally rectangular shape.

As can clearly be seen from the cross-sectional views of Fig. 5 and Fig. 6, the bottom plane of each region contacts the insulator layer 10 preventing the loss of the carriers in the vertical direction, and also the parasitic capacities associated with each region or the substrate is significantly small providing the lateral transistor with high speed switching ability.

The voltage actually applied to the emitter-base junction will be discussed now. As described above,

-10-

there is a significant voltage drop along the junction (moving away from the base contact region) due to the base current because of the high resistance of the first-base region 13 in its longitudinal direction. The graph of Fig. 7 schematically illustrates junction voltage distribution along the base-emitter junction for the lateral transistor of Fig. 3 and the graph of Fig. 8 schematically illustrates junction voltage distribution along the base-emitter junction of the lateral transistor of Fig. 4. In both Figures reference Bc denotes the position along the base-emitter junction nearest to the base contact, to which an external base voltage $V_b$ is applied, and reference Be denotes the position of an end of the junction (away from the base contact). For Fig. 7 and Fig. 8 it is assumed that base current Ib and applied base voltage $V_b$ are the same in relation to both Figures and it is assumed that longitudinal base resistivity (i.e. resistivity of the base region B in Fig. 3 and resistivity of first base region 13 in Fig. 4) is uniformly distributed and the same in relation to both Figures. From these curves, in the graphs of Figs. 7 and 8, it is clear that the lateral transistor of Fig. 4, an embodiment of the present invention, has a higher effective emitter-base junction voltage in total (overall). Accordingly, the carrier emitter efficiency is significantly improved as the number of carriers increases exponentially in proportion to the voltage applied to the junction.

Now a method of fabricating a lateral transistor embodying the present invention and having features generally as shown in Fig. 4 will be discussed with reference to Fig. 9 to 12.

First, a SOI substrate is prepared. A transistor region formed of a silicon monocrystal layer 11 of 0.5 to 1.0 μm thick is provided on an insulating layer 10 as shown in Fig. 9.

There are several methods which can be used for fabricating a monocrystal layer 11 on an insulating layer 10.

One method is to form a polycrystalline silicon layer (on an insulating layer) by a conventional chemical vapour deposition (CVD) method and then to recrystallize the polycrystalline silicon layer by heating with a laser beam, an electron beam, an infrared beam, etc. to convert its structure to a monocrystal structure.

Another method is to implant oxygen ions into a monocrystal substrate so that they concentrate at a specified depth below the surface of the substrate and to heat the substrate to form a silicon dioxide layer inside the substrate whilst retaining a monocrystal layer at the surface of the substrate. In this case, by a conventional method, field oxide regions (not shown) of silicon dioxide ($SiO_2$) can be formed in the silicon monocrystal layer to define (laterally) the transistor region.

The (whole) transistor region 11 is doped by implanting boron (B), for example, with a dose of $5 \times 10^{12 \sim 14}$ atm/cm$^2$ at 40 to 60 Kev and heating the substrate at approximately 1050$^{\circ}$C to diffuse the implanted dopant to form a diffusion region of around $10^{16 \sim 18}$ atm/cm$^3$ concentration (p-type doped region). Then, as shown in Fig. 10, by covering the surface of the substrate with a photo-resist layer 18 except for a portion corresponding to the base contact region 16 of the finished transistor, boron (B) dopants are again implanted again with a dose of around $10^{15}$ atm/cm$^2$ at 40 to 60 Kev, and the dopants are diffused to form the base contact region of $10^{19 \sim 20}$ atm/cm$^3$ concentration.

Following the formation of the base contact region 16, the substrate is covered again by a photoresist layer 19 as shown in Fig. 11, and a phosphorus implantation is effected with a dose of $5 \times 10^{15}$ atm/cm$^2$

and then heating is effected to form n-type diffusion regions of almost $10^{20}$ atm/cm$^3$ concentration which provide emitter region 12 and divided collector region portions (sub-collector regions) 14.

Finally, an insulator layer 21, and conductive paths 20 for the emitter region 12, the collector region 14 and the base contact region 16 are formed to finish a lateral bipolar transistor as shown in Fig. 12.

A plan view of the resulting lateral bipolar transistor having a base region structure in accordance with an embodiment of the prensent invention is illustrated in Fig. 13. It will be noted that this structure has two connecting portions 17 (as compared with only a single such portion in Fig. 4) for the base region, providing the emitter-base junction with further enhanced voltage to increase the emitter efficiency of the carriers in the first base region. This type of transistor structure is suitable for use in a relatively large type lateral transistor for handling high current.

Another lateral transistor embodying the present invention is illustrated in Fig. 14 which has a reduced base contact region 16 (as compared with the transistor of Fig. 4) sufficient only to form a base contact, with the aim of saving space on the substrate.

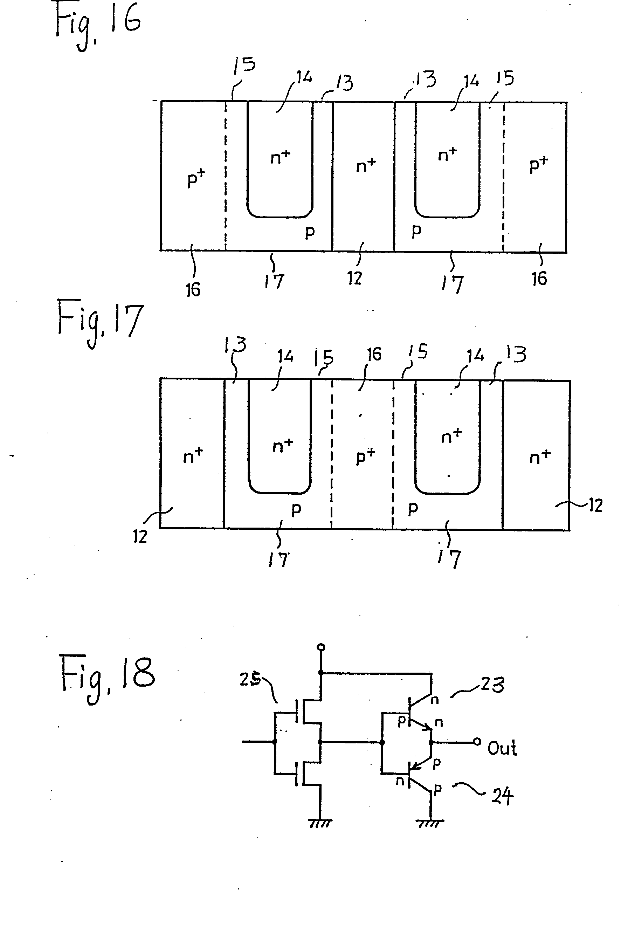

The plan view of Fig. 15 shows a different, simple lateral transistor structure which is suitable for forming a small type transistor embodying the present invention. In the structure of Fig. 15, the second base region differs from that seen in Fig. 4.

Fig. 16 and Fig. 17 illustrate further embodiments of the present in each of which two lateral transistor structures as shown in Fig. 15 are joined to form twinned lateral transistors. In Fig. 16 the twinned transistors have a common emitter region 12. In Fig. 17 the twinned transistors have common base contact region 16, namely, a common base contact. Such twinned lateral transistors are particularly suitable for saving space on the surface of an IC substrate to provide higher packing density and also saving IC fabrication costs.

Fig. 18 is a schematic circuit diagram of a circuit utilizing a npn lateral transistor 23 and a pnp lateral transistor 24 together with C MOS transistors 25. The lateral transistors 23 and 24 can be fabricated using the same fabricating process as is used for the C MOS transistors 25 without the need for additional fabrication steps. As such, the lateral transistors according to the present invention are most suitable for an output circuit of a C MOS (complementary metal oxide semiconductor) IC.

The embodiments of the present invention described above have all related to lateral transistors of n-p-n type but, of course, the present invention can clearly provide lateral transistors of the inverse type, p-n-p type.

In an embodiment of the present invention the base region and base contact region can be of a first conductivity type (either n or p) and the collector and emitter regions of a second (opposite) conductivity type (p or n). The second base region connects the first base region to the base contact region and extends along the collector region. The base, emitter and collector region are in surface - to surface contact with an underlying insulator of an SOI substrate.

It will be understood that the lateral transistors 23 and 24 in Fig. 18 can be provided by twinned lateral transistors as illustrated in Figs. 16 and 17.

An embodiment of the present invention provides a lateral bipolar transistor formed on a silicon on insulator (SOI) substrate, having a base region, a base contact region, an emitter region and a collector region. The base region comprises a first base region having a narrow base width and sharing an emitter-base junction with the emitter region. The base region also comprises a second base region extending laterally and partially surrounding the collector region and sharing a base-collector junction with the collector region. The base contact region is connected to the first base region (via the second base region). With this lateral transistor structure, base-emitter voltage is applied to the base-emitter junction more effectively by reducing voltage drop along the junction (along the first base region) due to base current flow, resulting in an enhancement of emitter efficiency of the carriers in the transistor region. The connecting portion (17) of the second base region extends transversely (e.g. perpendicularly) of the longitudinal extent of the first base region.

Claims:

1.     A lateral bipolar transistor, having a structure with a base region, a base contact region, an emitter region and a collector region, the base region comprising:

a first base region forming an emitter-base junction with the emitter region and a base-collector junction with the collector region; and

a second base region connecting the first base region to the base contact region and forming a base-collector junction with the collector region,

the base region, the emitter region and the collector region each being in surface-to-surface contact with an underlying insulator substrate portion.

2.     A transistor as claimed in claim 1, having a silicon on insulator substrate structure.

3.     A transistor as claimed in claim 1 or 2, wherein the second base region has a lower longitudinal resistance than the first base region.

4.     A transistor as claimed in claim 1, 2 or 3, wherein the lower longitudinal resistance of the second base region is provided by virtue of the second base region having a greater width than the first base region.

5.     A transistor as claimed in claim 1, 2, 3 or 4, wherein the second base region divides the collector region into sub-collector regions.

6.     A transistor as claimed in any preceding claim, wherein the second base region joins the first base region between opposite ends of the first base region.

7.     A transistor as claimed in any one of claim 1 to 4, wherein the second base region joins the first base region at one end of the first base region.

8.     A transistor as claimed in any preceding claim, wherein the base region includes a plurality of second base regions.

9.     A bipolar lateral transistor as claimed in any

0138563

-16-

preceding claim, wherein the collector region or each sub-collector region has a generally rectangular shape.

10. A lateral bipolar transistor formed of two lateral bipolar transistor structures as set forth in any preceding claim joined by a commonly possessed collector region, or joined by a commonly possessed emitter region, or joined by a commonly possessed base-contact region.

Fig. 1

Fig. 2

Fig. 3

2/5 · 0138563

Fig.4

Fig.5

Fig.6

Fig.7
junction voltage / position along the base region

Fig.8
junction voltage / position along the base region

3/5

**Fig. 9**

**Fig. 10**

**Fig. 11**

**Fig. 12**

0138563

Fig. 13

13

n+ 12

n+ 17

n+ p+ 16

p 17

n+

14 15

Fig. 14

13

n+ 12

n+ 14

p 17 15

n+ p+ 16

n+ 14

Fig. 15

13 14 15

n+ 12

n+ 16

p+

p 17

5|5

Fig. 16

Fig. 17

Fig. 18